# EUROPEAN PATENT APPLICATION

(11) **EP 2 434 032 A1**
(43) Date of publication of application: **28.03.2012**
(21) Application number: 10194191.2
(22) Date of filing: 08.12.2010
(51) Int. Cl.: C23C 14/06, C23C 30/00, B23B 27/14

(54) **Coated fine grained cermet for finish turning applications**

(71) Applicant: SECO TOOLS AB (publ), 737 82 Fagersta (SE)
(72) Inventor: Matsson, Peter, 774 33, Avesta (SE); Msaoubi, Rachid, 737 40, Fagersta (SE); Engström, Hindrik, 777 94, Söderbärke (SE)
(74) Representative: Hägglöf, Henrik

(57) **Abstract**

The present invention relates to a coated cutting tool insert for finish turning applications, comprising a substrate and a coating. The substrate is a cermet and the coating has a layer consisting essentially of (Ti₁₋ₓSiₓ)N, where x is between 0.1 and 0.25 and a total coating thickness between 0.5 and 4.0 µm.

## Description

The present invention relates to a coated cutting tool insert particularly useful for finish turning applications of iron based work piece material. Fine grained cermet substrates in combination with a TiSiN PVD-coating greatly improve tool life with surface criteria.

Finishing applications are a broad range of applications depending on what is considered to be the last operation on the specific component produced. However, the most common denominator for a finishing application is a surface roughness requirement. When low values of surface roughness are required cermet cutting tools are often used due to their chemical inertness and mechanical properties suited for small depths of cut and feeds.

Titanium-based carbonitride alloys, so-called cermets, are today well established as cutting tool materials in the metal cutting industry and are especially suited for finishing. They contain mainly carbonitride hard constituents embedded in a binder phase. The hard constituent grains generally have a complex structure with a core surrounded by a rim of another composition. Their grain size is usually <2 µm. In addition to the main constituent Ti, other metals of the groups IVa, Va and VIa, i.e., Zr, Hf, V, Nb, Ta, Cr, Mo, and/or W, are normally found in the carbonitride hard constituents but may also be present as separate carbide and/or nitride hard constituents. The binder phase generally contains cobalt and/or nickel. The amount of binder phase is generally 3-25% by weight.

WO 2010/071586 discloses a titanium based carbonitride alloy containing Ti, Nb, Ta, W, C, N and Co. The alloy contains - Co 7 to 21 wt % - W 14 to 20 wt % - Ta 5 to 11 wt % - Nb 2 to 7 wt % and, - Ti 33 to 50 wt % whereby the overall N/C weight ratio is 0.6 to 0.75, the Ta/Nb weight ratio 1.8 to 2.1, the relative saturation magnetization 0.60 to 0.90 and the magnetic coercivity Hc=(18.2-0.2*Co wt%) +/- E kA/m, where E is 2.0.

It is an object of the present invention to provide cutting tool insert yielding improved surface finish of the work piece in finish turning applications.

It has now surprisingly been found that a fine grained cermet coated with a layer consisting essentially of (Ti,Si)N, grown using physical vapor deposition greatly improves surface finish in finishing turning applications of iron based materials.

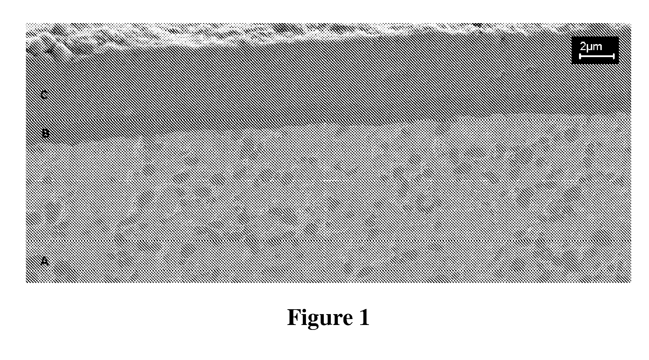

Fig 1 shows a scanning electron microscope image of a coated cutting tool insert in which
A - cermet substrate,
B - (Ti,Al)N layer and
C - (Ti,Al)N/(Ti,Si)N layer

According to the present invention there is now provided a coated cutting tool insert for finish turning applications, comprising a substrate and a coating. The substrate is a cermet and the coating comprises a layer consisting essentially of (Ti₁₋ₓSiₓ)N, where x is between 0.1 and 0.25, preferably between 0.12 and 0.23, and a total coating thickness between 0.5 and 4.0 µm, preferably between 1.5 and 3 µm, measured on the middle of the flank face.

In a preferred embodiment the substrate comprises 15-20 wt-% Co, 16-19 wt-% W, 6-9 wt Ta, 3-5 wt-% Nb, 37-47 Ti with a weight ratio Ta/Nb of 1.8-2.1 and N/C of 0.6-0.75. The relative saturation magnetization is 0.65-0.80 and the coercivity 13-16 kA/m.

In one embodiment the coating consists of two subsequent layers: a 0.1-1 µm thick TiₓAl₁₋ₓN layer 0.4<x<0.5 followed by a 1-3 µm nanolaminated Ti_{y}Al_{1-y}N+Ti_{z}Si_{1-z}N coating with 0.4<y<0.5 and 0.75<z<0.9. The average individual layer thickness is between 1 nm and 100 nm, preferably between 1 nm and 50 nm.

In another embodiment the coating consists of two subsequent layers: a 0.1-1 µm thick TiₓAl₁₋ₓN layer 0.4<x<0.5 followed by a 1-3 µm Ti₂Si_{1-z}N-layer with 0.75<z<0.9.

The cermet substrate of the present invention is made by conventional powder metallurgical methods: milling, pressing and sintering. The preferred substrate is made as disclosed in WO 2010/071586.

Before coating the cermet inserts are edge-honed by wet-blasting to an edge radius of preferably between 0 and 60 µm.

The deposition method for the coatings of the present invention is based on cathodic arc evaporation of an alloy or composite cathode under the following conditions; (Ti,Al)N and (Ti,Si)N layers are grown from cathodes yielding the desired layer composition. The evaporation current is between 50 A and 200 A. The layers are grown in an Ar + N₂ atmosphere, preferably in a pure N₂ atmosphere at a total pressure of 0.5 Pa to 9.0 Pa, preferably 1.5 Pa to 5.0 Pa. The bias is -10 V to -300 V, preferably -20 V to -200V. The deposition temperature is between 350 °C and 700 °C, preferably between 400 °C and 650 °C.

The present invention also relates to the use of a coated cutting tool according to above for finish turning applications of iron based work piece material at cutting speeds of 100-300 m/min, preferably 200-300 m/min, with an average feed of 0.05-0.25 mm, preferably 0.1-0.2 mm, with a depth of cut of 0.05-1.5 mm, preferably 0.1-1.0 mm, depending on cutting speed and insert geometry

### Example 1

A cermet cutting tool inserts of type DCMT11T304-F1 consisting of a substrate and a coating were prepared. The substrate was made by milling, pressing and sintering. The nominal powder composition was (wt%) Ti 40.8, Ta 7.2, Nb 3.7, Co 18.0, N 5.4, C 8.0 and rest W. The coercivity was 14.9 kA/m and relative saturation magnetization 0.7.

The inserts were wet-blasted to an edge-radius of 25 µm.

The coating was deposited from composite cathodes in 99.995% pure N₂ atmosphere at a total pressure of 2-6 Pa, using a bias of -20 to -60 V and an evaporation current of 60-200 A at 450°C.

Two subsequent layers were deposited during the same coating cycle, a 0.5 µm thick Ti_{0.45}Al_{0.55}N layer followed by a 2.0 µm nanolaminated Ti_{0.45}Al_{0.55}N/Ti_{0.80}Si_{0.20}N coating. The thickness of the individual layers was measured on the flank face of the inserts using scanning electron microscopy (SEM) in cross-section specimens, see figure 1.

### Example 2

A cermet cutting tool insert of type DCMT11T304-F1 consisting of a substrate and a coating were prepared. The substrate was made by milling, pressing and sintering. The nominal powder composition was (wt%) Ti 42.5, Ta 10.9, Nb 1.2, Co 8.9, Ni 4.4, Mo 0.4, N 6.1, C 8.1 and rest W. The inserts were wet-blasted to an edge-radius of 25µm.

The coating was deposited from composite cathodes in 99.995% pure N₂ atmosphere at a total pressure of 2-6 Pa, using a bias of -20 to -60 V and an evaporation current of 60-200 A at 450 °C.

Two subsequent layers were deposited during the same coating cycle, a 0.5 µm thick Ti_{0.45}Al_{0.55}N layer followed by a 2.0 µm Ti_{0.80}Si_{0.20}N coating. The thickness of the individual layers was measured on the flank face of the inserts using scanning electron microscopy (SEM) in cross-section specimens.

### Example 3

A cutting test was performed utilizing inserts of Type DCMT 11T304 with composition from example 1 (inside invention) and with the same composition as example one but with (Ti,Al)N coating (outside invention). Surface roughness was evaluated with Ra measurements.
Work piece material: DIN CK 45
Cutting speed: 280 m/min
Feed: 0.1 mm/rev
Depth of cut: 0.25 mm
Remarks: with coolant.

### Results

The surface finish after 30 min turning was:
Insert from example 1, Ra: 1.3 µm
Inserts from example 1 but with (Ti,Al)N coating, Ra: 2.1 µm

### Example 4

A cutting test was performed in a copying operation of a ball end utilizing inserts of Type TNMG 160408 with composition from example 2 (inside invention) and Seco Tools CMP grade (Cermet coated with (Ti,Al)N). Surface finish was criteria for tool life.
Work piece material: X27MnSiV6
Cutting speed: 120-200 m/min
Feed: 0.18 mm/rev
Depth of cut: 0.8 mm
Remarks: with coolant.

### Results

Insert from example 2: 920 components
Seco Tools CMP: 800 components

From the examples above it is clear that inserts produced according to the invention give substantially lower surface roughness of the work piece.

## Claims

1. A coated cutting tool insert for finish turning applications, comprising a substrate and a coating, **characterised in that** the substrate is a cermet and the coating comprises a layer consisting essentially of (Ti₁₋ₓSiₓ)N, where x is between 0.1 and 0.25, preferably between 0.12 and 0.23, and a total coating thickness between 0.5 and 4.0 µm, preferably between 1.5 and 3 µm, measured on the middle of the flank face.

2. Cutting tool insert according to claim 1
**characterised in that** the substrate comprises mainly carbonitride hard constituents in 5-25 % binder phase where the hard constituents contain, in addition to Ti, one or more of the metals Zr, Hf, V, Nb, Ta, Cr, Mo and/or W and the binder phase is based on cobalt and/or nickel.

3. Cutting tool insert according to claim 2
**characterised in that** the substrate comprises 15-20 wt-% Co, 16-19 wt-% W, 6-9 wt Ta, 3-5 wt-% Nb, 37-47 Ti with a weight ratio Ta/Nb of 1.8-2.1 and N/C of 0.6-0.75.

4. Cutting tool insert according to claim 3
**characterised in that** the relative saturation magnetization is 0.65-0.80 and the coercivity 13-16 kA/m.

5. Cutting tool insert according to any of the preceding claims
**characterised in that** the coating consists of two subsequent layers: a 0.1-1 µm thick TiₓAl₁₋ₓN layer 0.4<x<0.5 followed by a 1-3 µm nanolaminated Ti_{y}Al_{1-y}N/Ti_{z}Si_{1-z}N coating with 0.4<y<0.5 and 0.75<z<0.9.

6. Cutting tool insert according to claims 1-3
**characterised in that** the coating consists of two subsequent layers: a 0.1-1 µm thick TiₓAl₁₋ₓN layer 0.4<x<0.5 followed by a 1-3 µm Ti_{z}Si_{1-z}N-layer with 0.75<z<0.9.

7. Use of a coated cutting tool according to above for for finish turning applications of iron based work piece material at cutting speeds of 100-300 m/min, preferably 200-300 m/min, with an average feed of 0.05-0.25 mm, preferably 0.1-0.2 mm, with an depth of cut of 0.05-1.5 mm, preferably 0.1-1.0 mm, depending on cutting speed and insert geometry
